Europäisches Patentamt

European Patent Office

Office européen des brevets

(19)

(11) EP 0 735 282 A1

## (12) EUROPÄISCHE PATENTANMELDUNG

(43) Veröffentlichungstag:
02.10.1996 Patentblatt 1996/40

(51) Int. Cl.⁶: **F16B 2/06**, H05K 7/14, H02B 1/052

(21) Anmeldenummer: 96104577.0

(22) Anmeldetag: 22.03.1996

(84) Benannte Vertragsstaaten:
AT BE CH DE DK ES FI GB IT LI LU NL PT SE

(30) Priorität: 28.03.1995 DE 19511329

(71) Anmelder: ABB
PATENT GmbH
D-68309 Mannheim (DE)

(72) Erfinder:
• Zengerle, Manfred
67280 Ebertsheim (DE)
• Fangmeyer, Siegfried
68309 Mannheim (DE)

(74) Vertreter: Rupprecht, Klaus, Dipl.-Ing. et al
c/o ABB Patent GmbH,
Postfach 10 03 51
68128 Mannheim (DE)

(54) **Baugruppen-Befestigungssystem**

(57) Es wird ein Baugruppen-Befestigungssystem zur Befestigung einer Baugruppe auf einer Führungsschiene vorgeschlagen, wobei die Führungsschiene (1) über einen Seitenabschnitt (3, 4) und einen hierzu abgewinkelten Führungsabschnitt (5, 6) in einen Führungsschlitz (9) und einen hierzu abgewinkelten Seitenschlitz (10, 11) der Baugruppe (7, 8) eingreift und die Baugruppe längs der Führungsschiene verschiebbar, jedoch horizontal und vertikal über die Abschnitte (3, 4, 5, 6) bzw. Schlitze (9, 10, 11) arretiert ist. Wesentlich ist eine Befestigungsplatte (12), die mit der Baugruppe (7, 8) verbindbar ist und in deren Führungsschlitz (13) bzw. hierzu abgewinkelten Seitenschlitz (14) die Führungsschiene (1) über ihren Seitenabschnitt (3, 4) bzw. Führungsabschnitt (5, 6) eingreift, wobei die Seitenwandungen (15, 16) des Seitenschlitzes (14) um vorgegebene Winkel ($\gamma$, $\beta$) gegenüber der Grundfläche (21) der Befestigungsplatte (12) gekippt sind. Die Befestigungsplatte ist somit frei längs der Führungsschiene (1) beweglich, wenn die Grundfläche (21) der Befestigungsplatte um einen vorgegebenen Winkel ($\alpha$) gegenüber der Stirnfläche (22) der Baugruppe gekippt ist, jedoch durch Reibung zwischen den Seitenwandungen (15, 16) und dem Führungsabschnitt (5, 6) der Führungsschiene (1) arretiert, wenn die Grundfläche (21) der Befestigungsplatte und die Stirnfläche (22) der Baugruppe parallel verlaufen, was durch Montage der Befestigungsplatte an der Baugruppe erfolgt.

Fig. 1

EP 0 735 282 A1

Printed by Rank Xerox (UK) Business Services
2.13.6/3.4

## Beschreibung

Die Erfindung bezieht sich auf ein Baugruppen-Befestigungssystem gemäß dem Oberbegriff des Anspruchs 1. Ein derartiges Baugruppen-Befestigungssystem ist auf dem Gebiet der Stromrichtertechnik allgemein bekannt.

Dabei werden einzelne Baugruppen wie Schubladen in entsprechende Führungsschienen geschoben. Eine Schiene wird von zwei benachbarten Baugruppen genutzt. Als Anschlag dient eine elektrische Anschlußfahne. Zur horizontalen Lagesicherung wird ein Klemmstein in die Schiene eingeschoben und verklemmt.

Die Baugruppen (Einschübe) haben auf der Schiene gegebenermaßen Spiel sowohl in horizontaler wie in vertikaler Richtung. Der Klemmstein kann bei benachbarten Einschüben aus Toleranzgründen immer nur einen Einschub horizontal in einer Richtung festhalten. In der Gegenrichtung muß diese Aufgabe von einem anderen Element ausgeführt werden. Vertikale Bewegungen können von dem Klemmstein auf keinen Fall verhindert werden. Es müssen also noch weitere zusätzliche Haltevorrichtungen montiert werden, um die Einschübe vor Bewegungen zu schützen und um somit deren elektrische Anschlüsse vor mechanischen Beanspruchungen zu bewahren. Diese zusätzlichen Haltevorrichtungen sind aus Platzgründen bzw. wegen schlechter Zugänglichkeit nur schwer zu realisieren.

Der Erfindung liegt die Aufgabe zugrunde, ein Baugruppen-Befestigungssystem der eingangsgenannten Art anzugeben, das auf möglichst einfache und leicht ausführbare Art und Weise eine sichere horizontale als auch vertikale Befestigung einer Baugruppe gewährleistet.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile liegen insbesondere darin, daß die zusätzlich erforderliche Befestigungsplatte kostengünstig herstellbar ist und gleichzeitig die horizontale und vertikale Befestigung der Baugruppe in sehr schneller Art und Weise ermöglicht. Hierzu muß lediglich die Befestigungsplatte mit der Baugruppe verbunden werden, was beispielsweise sehr einfach mittels einer Verschraubung erfolgt. Die Befestigungsplatte benötigt sehr wenig Platz und ist leicht an der Stirnseite der Baugruppe zugänglich, was einen sehr einfachen Ein- und Ausbau auch unter beengten Platzverhältnissen ermöglicht.

Üblicherweise werden eine Vielzahl von Baugruppen innerhalb eines Schranksystem befestigt, wobei jede Baugruppe vorteilhaft unabhängig von benachbarten Baugruppen eingebaut, befestigt und ausgebaut werden kann. Soll eine erhöhte Haltekraft aufgebracht werden, so können mehrere Befestigungsplatten aufeinandergelegt und gemeinsam befestigt werden.

Die Erfindung wird nachstehend anhand der in der Zeichnung dargestellten Ausführungsformen erläutert. Es zeigen:

Fig. 1      eine Sicht auf die Stirnfläche einer Baugruppen-Befestigung,

Fig. 2      eine perspektivische Ansicht einer Befestigungsplatte,

Fig. 3      einen Schnitt durch eine Baugruppen-Befestigung,

Fig. 4      die Positionen von Baugruppe, Führungsschiene und Befestigungsplatte vor der Arretierung,

Fig. 5      eine Prinzipskizze zu den für die Anordnung wichtigen Winkeln

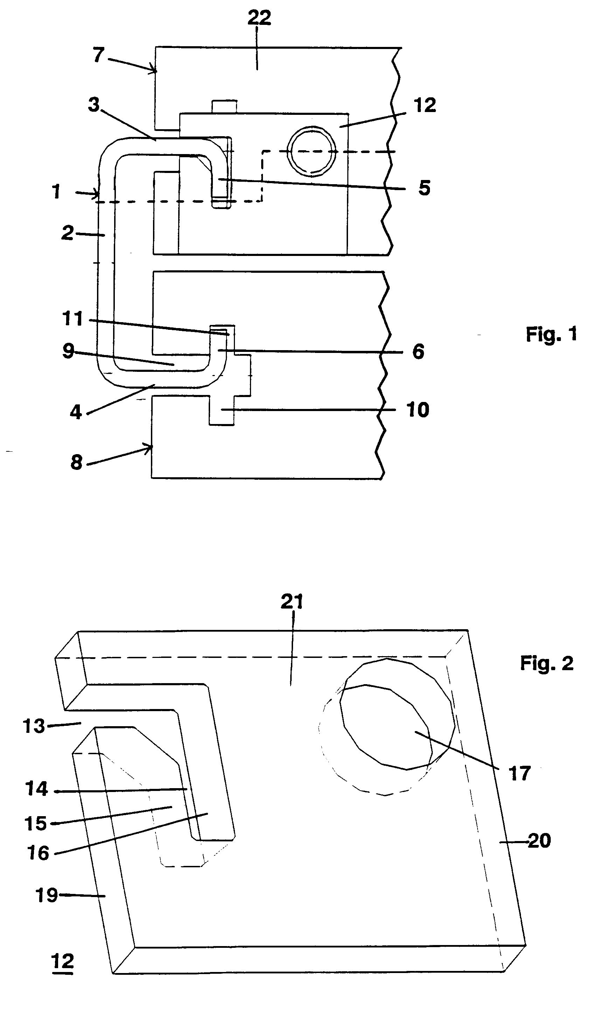

In Fig. 1 ist eine Sicht auf die Stirnfläche einer Baugruppen-Befestigung dargestellt. Es ist eine im Querschnitt C-förmige Führungsschiene 1 zu erkennen, mit einem mittleren Basisabschnitt 2, zu dessen beiden Seiten sich rechtwinklig Seitenabschnitte 3, 4 anschließen, die wiederum rechtwinklig in aufeinander zuweisende Führungsabschnitte 5, 6 übergehen. Die derart ausgebildete Führungsschiene 1 ist zur Führung und zur Befestigung von zwei Baugruppen 7, 8 (Einschüben) geeignet, wobei jede der Baugruppen von zwei Führungsschienen gehalten wird.

Für den Eingriff der Führungsschienen weisen die Baugruppen Führungsschlitze 9 auf, die jeweils mit hierzu rechtwinklig angeordneten Seitenschlitzen 10, 11 versehen sind. Die Dimensionierung und Anordnung der Führungsschlitze/Seitenschlitze 9/10/11 ist derart, daß ein leichtgängiges Gleiten auf den Seitenabschnitten/Führungsabschnitten 3/4/5/6 der Führungsschienen 1 ermöglicht wird. Zur Arretierung der Baugruppen auf der Führungsschiene 1 dienen Befestigungsplatten 12, deren Aufbau und Funktion nachfolgend erläutert wird.

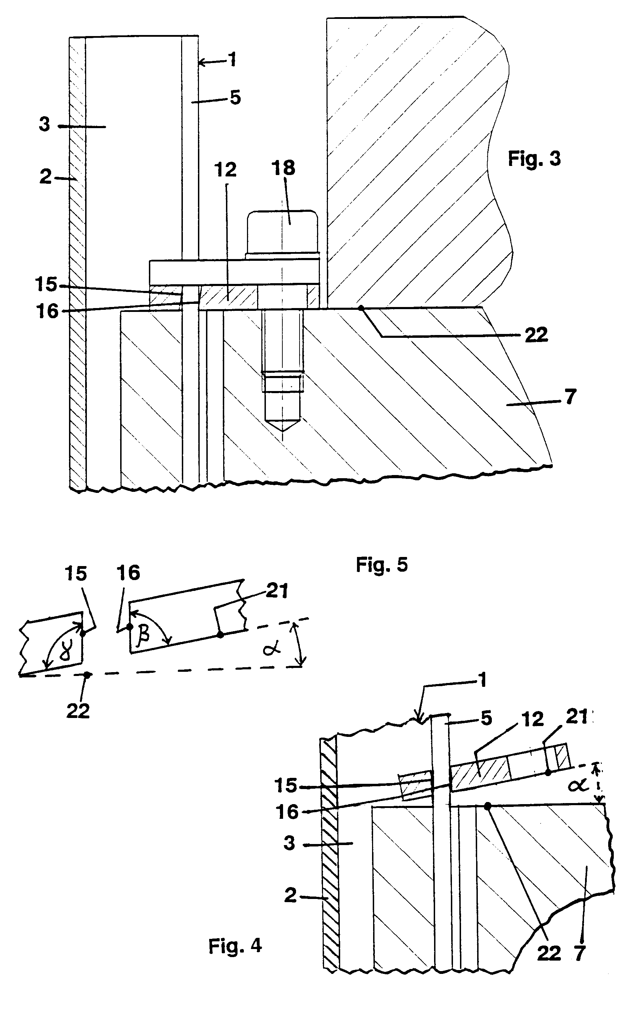

In Fig. 2 ist eine perspektivische Ansicht einer Befestigungsplatte 12 dargestellt. Die Befestigungsplatte 12 weist eine quaderförmige Grundstruktur auf. Ausgehend von einer Seitenfläche 19 verläuft rechtwinklig dazu ein Führungsschlitz 13 in die Befestigungsplatte und geht rechtwinklig in einen Seitenschlitz 14 über. Wesentlich ist dabei, daß die Seitenwandungen 15, 16 des Seitenschlitzes 14 nicht rechtwinklig bezüglich der Grundfläche 21 der Befestigungsplatte ausgebildet, sondern hierzu um bestimmte, vorgegebene Winkel gekippt sind (siehe Fig. 5).

In der Nähe der der Seitenfläche 19 gegenüberliegenden Seitenfläche 20 befindet sich eine die Grundfläche 21 durchstoßende Bohrung 17 in der Befestigungsplatte. Die Dimensionierung und Ausgestaltung der Schlitze 13/14 ist derart, daß ein Eingriff eines Seitenabschnitts 3/4 und eines Führungsabschnitts 5/6 der Führungsschiene 1 erfolgen kann, wobei die Befestigungsplatte 12 nicht parallel zur Stirnfläche 22 (siehe Fig. 1) der Baugruppe eingesetzt werden muß, sondern um den vorgegebenen Winkel α gekippt hierzu (siehe hierzu Fig. 4).

In Fig. 3 ist ein Schnitt durch eine Baugruppen-Befestigung dargestellt. Die Schnittfläche ist dabei gestrichelt in Fig. 1 angedeutet. Es ist die Führungsschiene 1 mit ihrem Basisabschnitt 2 (geschnitten), ihrem Seitenabschnitt 3 und ihrem Führungsabschnitt 5 zu erkennen. Die Befestigungsplatte 12 ist über ihre Bohrung mittels einer Befestigungsschraube 18 an die Stirnfläche 22 der Baugruppe 7 gepreßt, so daß die Seitenwandungen 15, 16 des Seitenschlitzes 14 über ihre Kanten gegen die Seitenflanken des Führungsabschnitts 5 gepreßt werden. Hierdurch wird die Befestigungsplatte 12 und somit die mit ihr verschraubte Baugruppe 7 unverrückbar an der Führungsschiene 1 arretiert.

Nach Lösen der Befestigungsschraube 18 und Kippen der Befestigungsplatte 12 - derart, daß die Seitenwandungen 15, 16 des Seitenschlitzes 14 etwa parallel zum Führungsabschnitt 5 der Führungsschiene 1 verlaufen - läßt sich die Befestigungsplatte und somit die Baugruppe bewegen und beispielsweise aus der Führungsschiene herausziehen.

In Fig. 4 sind die Positionen von Baugruppe, Führungsschiene und Befestigungsplatte vor der Arretierung dargestellt. Wie zu erkennen ist, wird der Winkel α zwischen Grundfläche 21 der Befestigungsplatte 12 und Stirnfläche 22 der Baugruppe 7 eingeschlossen, wenn die Befestigungsplatte derart positioniert ist, daß die Seitenwandungen 15, 16 des Seitenschlitzes 14 parallel zum Führungsabschnitt 5 der Führungsschiene 1 verlaufen.

Fig. 5 zeigt eine Prinzipskizze zu den für die Anordnung wichtigen Winkeln. Um den Winkel α ist die Grundfläche 21 der Befestigungsplatte 12 gegenüber einer Stirnfläche 22 der Baugruppe 7 zu kippen, um die Beweglichkeit der Befestigungsplatte längs der Führungsschiene zu ermöglichen. Zwischen der Seitenwandung 15 des Seitenschlitzes 14 und der Grundfläche 21 ist der Winkel γ eingeschlossen. Es gilt γ = 90° + α. Zwischen der Seitenwandung 16 des Seitenschlitzes 14 und der Grundfläche 21 ist der Winkel β eingeschlossen, wobei β = 90° - α.

Allgemein ist zum vorstehend beschriebenen Baugruppen-Befestigungssystem zu ergänzen, daß die Befestigungsplatte 12 nicht über die Baugruppe 7 hinausragen sollte, um den Einbau, die Befestigung und den Ausbau von benachbarten Baugruppen innerhalb eines Baugruppenschrankes unabhängig voneinander zu gewährleisten. Führungsschlitz 13 und Seitenschlitz 14 der Befestigungsplatte 12 sollten nur wenig Spiel bezüglich des Seitenabschnittes 3 und des Führungsabschnittes 5 der Führungsschiene 1 aufweisen, um einerseits ein Gleiten der Befestigungsplatte auf der Führungsschiene und andererseits eine rüttelsichere Befestigung der Baugruppe an der Führungsschiene sicherzustellen.

Von Wichtigkeit ist, daß sich die Befestigungsplatte 12 beim Einschrauben der Befestigungsschraube 18 an die Stirnfläche der Baugruppe 7 anlegt, wodurch sich Seitenwandungen 15, 16 und Führungsabschnitt 5 verkeilen. Sollte dabei eine erhöhte Haltekraft (Reibung) nötig sein, werden mehrere Befestigungsplatten 12 aufeinandergelegt und festgeschraubt.

## Patentansprüche

1. Baugruppen-Befestigungssystem zur Befestigung einer Baugruppe auf einer Führungsschiene, wobei die Führungsschiene (1) über einen Seitenabschnitt (3, 4) und einen hierzu abgewinkelten Führungsabschnitt (5, 6) in einen Führungsschlitz (9) und einen hierzu abgewinkelten Seitenschlitz (10, 11) der Baugruppe (7, 8) eingreift und die Baugruppe längs der Führungsschiene verschiebbar, jedoch horizontal und vertikal über die Abschnitte (3, 4, 5, 6) bzw. Schlitze (9, 10, 11) arretiert ist, gekennzeichnet durch eine Befestigungsplatte (12), die mit der Baugruppe (7, 8) verbindbar ist und in deren Führungsschlitz (13) bzw. hierzu abgewinkelten Seitenschlitz (14) die Führungsschiene (1) über ihren Seitenabschnitt (3, 4) bzw. Führungsabschnitt (5, 6) eingreift, wobei die Seitenwandungen (15, 16) des Seitenschlitzes (14) um vorgegebene Winkel (γ, β) gegenüber der Grundfläche (21) der Befestigungsplatte (12) gekippt sind, wodurch die Befestigungsplatte frei längs der Führungsschiene (1) beweglich ist, wenn die Grundfläche (21) der Befestigungsplatte um einen vorgegebenen Winkel (α) gegenüber der Stirnfläche (22) der Baugruppe gekippt ist, jedoch durch Reibung zwischen den Seitenwandungen (15, 16) und dem Führungsabschnitt (5, 6) der Führungsschiene (1) arretiert ist, wenn die Grundfläche (21) der Befestigungsplatte und die Stirnfläche (22) der Baugruppe parallel verlaufen, was durch Montage der Befestigungsplatte an der Baugruppe erfolgt.

2. Baugruppen-Befestigungssystem nach Anspruch 1, dadurch gekennzeichnet, daß die Montage der Befestigungsplatte (12) an der Baugruppe (7, 8) durch eine Verschraubung erfolgt, wozu die Grundfläche (21) mit einer Bohrung (17) zur Durchführung einer Befestigungsschraube (18) versehen ist.

Fig. 1

Fig. 2

EP 0 735 282 A1

Fig. 3

Fig. 5

Fig. 4

5

Europäisches Patentamt

## EUROPÄISCHER RECHERCHENBERICHT

Nummer der Anmeldung

EP 96 10 4577

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | DE-B-11 58 145 (SIEMENS-SCHUCERTWERKE AG) * das ganze Dokument * --- | 1 | F16B2/06 H05K7/14 H02B1/052 |
| A | AT-A-291 685 (WERTHEIM-WERKE AG ) 15.November 1970 * Seite 1, Zeile 19 - Zeile 31 * --- | 1 | |
| A | DE-A-22 45 362 (SIEMENS AG) 21.März 1974 * Seite 2, Absatz 3 * --- | 1 | |
| A | DE-A-18 03 760 (LICENTIA PATENT-VERWALTUNGS-GMBH) 4.Juni 1970 * Seite 4, Absatz 2 - Seite 5, Absatz 1 * --- | 1 | |
| A | FR-A-2 657 037 (SAUVAGEOT GEORGES) 19.Juli 1991 ----- | | |

RECHERCHIERTE SACHGEBIETE (Int.Cl.6)

F16B
H05K
H02B

Der vorliegende Recherchenbericht wurde für alle Patentansprüche erstellt

| Recherchenort | Abschlußdatum der Recherche | Prüfer |
|---|---|---|
| DEN HAAG | 28.Juni 1996 | Toussaint, F |

EPO FORM 1503 03.82 (P04C03)